Europäisches Patentamt

European Patent Office

Office européen des brevets

(19)

(11) Veröffentlichungsnummer: **0 009 599**
**A1**

(12) **EUROPÄISCHE PATENTANMELDUNG**

(21) Anmeldenummer: **79103075.2**

(22) Anmeldetag: **21.08.79**

(51) Int. Cl.³: **G 11 B 5/02**
**H 03 F 3/72**

(30) Priorität: **29.09.78 DE 2842602**

(43) Veröffentlichungstag der Anmeldung:
**16.04.80 Patentblatt 80/8**

(84) Benannte Vertragsstaaten:
**AT BE CH FR GB IT NL**

(71) Anmelder: **SIEMENS AKTIENGESELLSCHAFT Berlin und München**
**Postfach 22 02 61**
**D-8000 München 22(DE)**

(72) Erfinder: **Haarpaintner, Anton**
**Glonnerstrasse 6**
**D-8011 Grosshelfendorf(DE)**

(54) Schaltungsanordnung zum Verringern des Rauschens im Lesesignal von Magnetschichtspeichern.

(57) Als Eingangsstufe des Leseverstärkers (4) sind Feldeffekttransistoren (12, 13) vorgesehen, deren Gate-Elektroden (14, 15) unmittelbar mit den Schreib-/Lese-Leitungen (2) für die Magnetköpfe (1) verbunden sind und deren Source-Elektroden (16, 17) durch hohe Spannungen gesteuert werden.

EP 0 009 599 A1

./...

Fig. 2

SIEMENS AKTIENGESELLSCHAFT     Unser Zeichen

Berlin und München     VPA

78 P 2 0 6 9 EUR

Schaltungsanordnung zum Verringern des Rauschens im Lesesignal von Magnetschichtspeichern

Die Erfindung bezieht sich auf eine Schaltungsanordnung zum Verringern des Rauschens im Lesesignal von Magnetschichtspeichern mit mindestens einem Übertragerkopf, der sowohl zum Schreiben als auch zum Lesen von Informationen vorgesehen und hierzu über Schreib-/Lese-Leitungen sowohl an eine Schreibstromquelle als auch an einen Leseverstärker angeschlossen ist.

Es ist bekannt, zum Schreiben und Lesen von Informationen auf magnetisierbaren Aufzeichnungsflächen, wie z.B. Magnetbändern oder Magnetplatten, jeweils einen getrennten Schreib- bzw. Lesekopf zu verwenden. Die zugehörigen Schreib- und Leseverstärker lassen sich dabei vollkommen getrennt voneinander aufbauen und schalten. Dies hat zwar den Vorteil einer vollkommen entkoppelten Schaltung, weist aber den Nachteil auf, daß stets zwei Magnetköpfe in Bezug auf die ihr zugeordnete Aufzeichnungsspur eingestellt werden müssen.

Kar 1 Sur / 28.9.1978

Es sind deshalb, insbesondere in Verbindung mit Magnettrommel- und Magnetplattenspeichern, Schaltungsanordnungen bekannt geworden, die es ermöglichen, ein und denselben Magnetkopf sowohl zum Schreiben als auch zum Lesen
der Information zu verwenden. Bei solchen Schaltungsanordnungen ergibt sich aber zwangsläufig eine gewisse
Verkopplung von Schreib- und Leseverstärker. Da beim
Schreiben an der Wicklung des Magnetkopfes Spannungsspitzen von mehreren Volt auftreten können, andererseits
aber die Lesespannungen in den meisten Fällen nur Werte
von mehreren Millivolt erreichen, liegen die von der
Schaltungsanordnung zu verarbeitenden Signale um Größenordnungen auseinander. Bei einer Verkopplung von Schreib-
und Leseverstärkern besteht deshalb die Gefahr, daß der
Leseverstärker von den hohen, beim Schreiben auftretenden Spannungsspitzen übersteuert wird und anschließend
eine längere Zeit benötigt, bis er zum Verstärken der
sehr viel geringeren Lesespannungen wieder betriebsbereit ist. Auch eine Zerstörung des Leseverstärkers ist
möglich.

Um einerseits den Leseverstärker gegen diese beim Schreiben auftretenden hohen Spannungsspitzen zu blockieren,
andererseits aber die im Verhältnis zu den Schreibspannungen niedrigen Lesespannungen während des Lesens praktisch ungeschwächt durchzulassen, dienen in der Regel
Diodenschaltungen aus zwei gegenseitig in Reihe geschalteten Dioden vor jeder Eingangsklemme des Leseverstärkers. Diese Dioden erfüllen die an sie gestellten Forderungen nach Entkopplung von Schreib- und Leseverstärker
an sich recht gut. Sie weisen aber noch den Nachteil auf,
einen nicht zu vernachlässigenden Anteil zum Gesamtrauschen im Lesesignal des Leseverstärkers beizutragen.

Der Erfindung liegt daher die Aufgabe zugrunde, eine
Schaltungsanordnung der eingangs genannten Art zu schaffen, die ohne solche Entkopplungsdioden auskommt und somit eine Erniedrigung des Rauschens im Lesesignal bewirkt. Man könnte an sich daran denken, die Entkopplungsdioden im Eingang des Leseverstärkers einfach wegzulassen und stattdessen die Basis-Emitterstrecken der Eingangstransistoren des Leseverstärkers durch Anlegen entsprechend hoher Spannungen jeweils zu sperren. Diese Lösung scheitert aber daran, daß Transistoren, die derart hohe Sperrspannungen vertragen, in der Regel nicht rauscharm sind, bzw. die rauscharmen Transistoren keine genügend hohe Sperrspannungen aufweisen. Erfindungsgemäß wird deshalb die Aufgabe dadurch gelöst, daß als Eingangsstufe des Leseverstärkers Feldeffekttransistoren vorgesehen sind, daß die Gate-Elektroden der Feldeffekttransistoren unmittelbar mit der Schreib-/Lese-Leitung verbunden sind und daß die Feldeffekttransistoren durch hohe Spannungen an den Sourceelektroden gesteuert werden. Mit einer solchen Schaltungsanordnung läßt sich das Rauschen im Lesesignal um all jene Anteile verringern, die von den bisher üblichen Entkopplungsdioden herrühren, ohne daß dafür ein erhöhtes Rauschen der Eingangsstufe des Leseverstärkers in Kauf genommen werden müßte.

Weitere Einzelheiten der Erfindung ergeben sich aus der nachfolgenden Beschreibung eines vorteilhaften Ausführungsbeispieles derselben. Dabei zeigt

Fig. 1   eine bekannte Schaltung mit Entkopplungsdioden und

Fig. 2   eine Schaltungsanordnung gemäß der Erfindung.

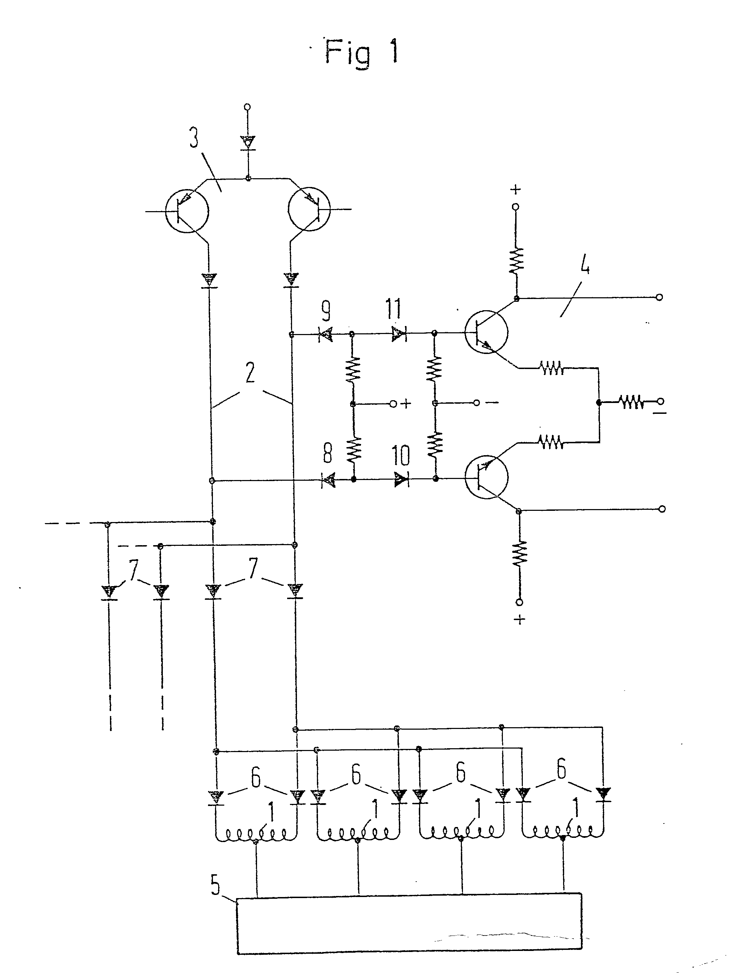

Die Schaltungsanordnung von Fig. 1 zeigt eine Reihe von Magnetköpfen 1, die über zwei Leitungen 2 zum einen mit einer Schreibstromquelle 3 und zum anderen mit einem Leseverstärker 4 verbunden sind. Aus der Vielzahl der Magnetköpfe 1 kann ein bestimmter Magnetkopf in bekannter

Weise durch eine Kopfauswahlschaltung 5 in Verbindung mit den Kopfauswahldioden 6 und 7 ausgewählt werden.

Der Leseverstärker 4 ist über je eine Reihenschaltung aus zwei gegensinnig geschalteten Dioden 8, 10 bzw. 9, 11 mit den beiden Schreib-/Lese-Leitungen 2 verbunden. Diese Dioden 8, 9, 10 und 11 haben die Aufgabe, den Lesekreis beim Schreibvorgang vom Schreibkreis zu entkoppeln und ihn vor einer Blockierung oder Zerstörung durch die an der Kopfwicklung beim Umschalten der Schreibstromrichtung auftretenden Gegenspannungsspitzen zu schützen. Außerdem soll durch diese Dioden jede unerwünschte Beeinflussung (z.B. Bedämpfung) des Schreibkreises durch den Lesekreis vermieden werden.

Jede der im Schreibkreis liegenden Dioden 6, 7, 8, 9, 10 und 11 trägt zu einem gewissen Teil zu dem Rauschen im Lesesignal bei. Es ist deshalb erwünscht, die Zahl der Dioden im Lesekreis so gering wie möglich zu halten. Die Dioden 6 und 7 zur Kopfauswahl können nicht ohne weiteres ersetzt werden. Bei Ausgestaltung einer Schaltungsanordnung gemäß der Erfindung ist es aber möglich, die Dioden 8, 9, 10 und 11 zu eliminieren.

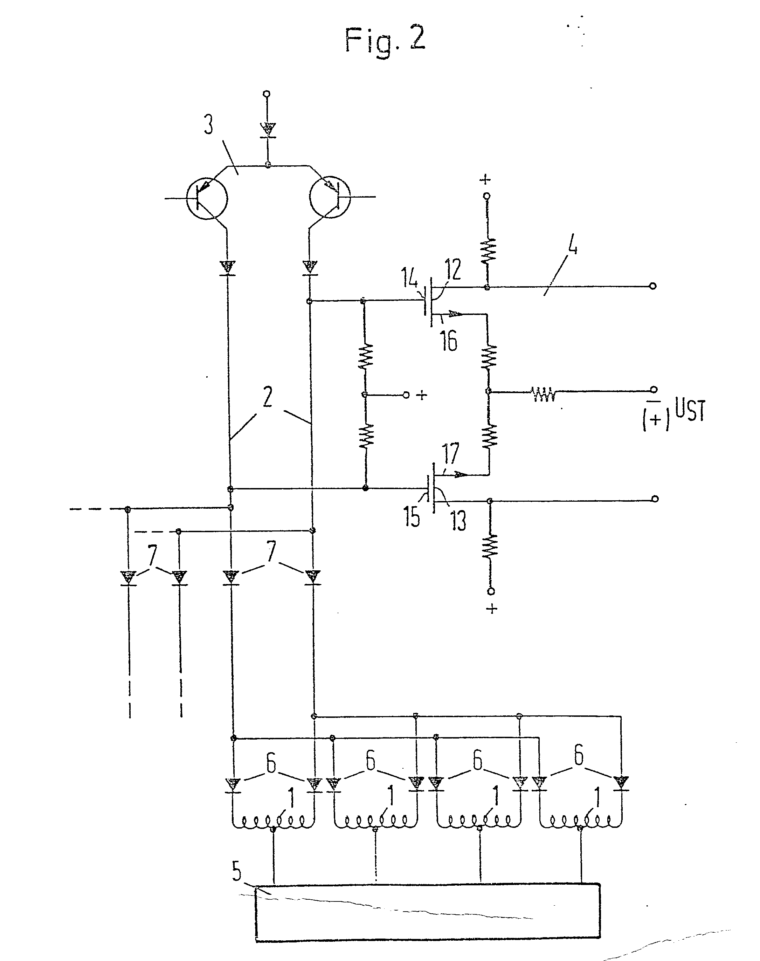

Aus Fig. 2 ist ersichtlich, daß als Eingangsstufe des Leseverstärkers 4 Feldeffekttransistoren 12 und 13 vorgesehen sind und daß die Gate-Elektroden 14 bzw. 15 der Feldeffekttransistoren 12 und 13 unmittelbar mit den Schreib-/Lese-Leitungen 2 verbunden sind. Durch die Verwendung von Feldeffekttransistoren als Eingangsstufe des Leseverstärkers 4 ist es möglich, vollständig auf die Verwendung der ansonsten üblichen Entkopplungsdioden (Dioden 8, 9, 10 und 11 von Fig. 1) zu verzichten, denn die Feldeffekttransistoren haben den Vorteil, daß sie bei großer Rauscharmut mit sehr hohen Sperrspannungen $U_{ST}$ betrieben werden können. Dies bedeutet, daß der Lese-

0009599

verstärker 4 nur durch Anlegen einer entsprechend hohen Spannung $U_{ST}$ an die Source-Elektroden 16, 17 während des Schreibvorganges sicher gegen die dabei auf den gemeinsamen Schreib-/Lese-Leitungen 2 auftretenden Spannungsspitzen vor Zerstörung geschützt werden kann. Während des Lesevorganges werden die Feldeffekttransistoren 12 und 13 des Leseverstärkers 4 einfach durch Anlegen einer entsprechenden Spannung $U_{ST}$ an die Source-Elektroden 16, 17 durchlässig gesteuert.

Auf diese Weise erreicht man eine Schaltungsanordnung, bei der durch Weglassen der bisher üblichen Entkopplungsdioden das Rauschen im Lesesignal wesentlich verringert ist und bei der außerdem jegliche Schwächung des Lesesignals dadurch vermieden wird, daß keinerlei zusätzliche Schaltelemente zwischen die Schreib-/Lese-Leitungen 2 und die Eingangselektroden 14 bzw. 15 der Feldeffekttransistoren 12 bzw. 13 des Leseverstärkers 4 geschaltet sind.

79103075.2

0009599

VPA 78 P 2069 EUR

## Bezugszeichenliste

| | |
|---|---|
| 1 | Magnetköpfe |
| 2 | Schreib-/Lese-Leitungen |
| 3 | Schreibstromquelle |
| 4 | Leseverstärker |
| 5 | Kopfauswahlschaltung |
| 6 | Kopfauswahldioden |
| 7 | " |
| 8 | Entkopplungsdioden |
| 9 | " |
| 10 | " |
| 11 | " |
| 12 | Feldeffekttransistoren |
| 13 | " |
| 14 | Gate-Elektroden |
| 15 | " |
| 16 | Source-Elektroden |
| 17 | " |
| $U_{ST}$ | Sperrspannungen |

Patentanspruch

Schaltungsanordnung zum Erniedrigen des Rauschens im Lesesignal von Magnetschicht- insbesondere Magnetplattenspeichern mit mindestens einem Übertragerkopf, der sowohl zum Schreiben als auch zum Lesen von Informationen vorgesehen und hierzu über gemeinsame Schreib-/Lese-Leitungen sowohl an eine Schreibstromquelle als auch an einen Leseverstärker angeschlossen ist, d a d u r c h g e k e n n z e i c h n e t , daß als Eingangsstufe des Leseverstärkers (4) Feldeffekttransistoren (12, 13) vorgesehen sind, daß die Gate-Elektroden (14, 15) der Feldeffekttransistoren unmittelbar mit den Schreib-/Lese-Leitungen (2) verbunden sind und daß die Feldeffekttransistoren durch hohe Spannungen ($U_{ST}$) an den Source-Elektroden (16, 17) gesteuert werden.

## Fig 1

Fig. 2

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | GB - A - 942 032 (OLYMPIA WERKE)  * Figuren 1-3; Seite 2, Zeile 70 - Seite 3, Zeile 87 *  -- | 1 | G 11 B 5/02 H 03 F 3/72 |
| A | US - A - 4 044 387 (SPERRY RAND)  * Figur 4; Spalte 4, Zeile 59 - Spalte 6, Zeile 2 *  -- | 1 | |
| A | CH - A - 525 587 (SIEMENS-ALBIS A.G.)  -- | 1 | |
| A | US - A - 3 824 623 (GUCKER)  * Figuren 2,3; Spalte 2, Zeile 63 - Spalte 5, Zeile 60 *  -- | 1 | |
| A | US - A - 3 810 135 (HITACHI)  * Figur; Spalte 2, Zeile 43 - Spalte 4, Zeile 47 *  -- | 1 | |
| A | IBM TECHNICAL DISCLOSURE BULLETIN, Vol. 14, Nr. 4, September 1971, Seiten 1183-1184 New York, U.S.A. O.R. BUHLER: "Analog Switch"  ---- | 1 | |

**RECHERCHIERTE SACHGEBIETE (Int. Cl. 3)**

```
G 11 B   5/02
         5/027
         5/012
G 11 C  11/065
        11/067
        11/14
G 11 B  15/12
H 03 F   3/68
         3/72
```

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsatze
E: kollidierende Anmeldung
D: in der Anmeldung angeführtes Dokument
L: aus andern Grunden angeführtes Dokument
&: Mitglied der gleichen Patentfamilie übereinstimmendes Dokument

Der vorliegende Recherchenbericht wurde für alle Patentansprüche erstellt

| Recherchenort | Abschlußdatum der Recherche | Prufer |
|---|---|---|
| Den Haag | 17-12-1979 | CARTEIJSSE |

EPA form 1503.1   06.78